# EUROPÄISCHE PATENTANMELDUNG

(11) **EP 0 903 786 A2**
(43) Veröffentlichungstag der Anmeldung: **24.03.1999**
(21) Anmeldenummer: 98117050.9
(22) Anmeldetag: 09.09.1998
(51) Int. Cl.: H01L 25/13

(54) **Leuchtdioden-Array und Verfahren zu seiner Herstellung**

(30) Priorität: 20.09.1997 DE 19741585
(71) Anmelder: Parsytic Computer GmbH, 52068 Aachen (DE)
(72) Erfinder: Bavendiek, Klaus, Dr., 52146 Würselen (DE); Melms, Michael, 52159 Roetgen (DE)
(74) Vertreter: Lins, Edgar, Dipl.-Phys. Dr.jur.

(57) **Zusammenfassung**

Ein Leuchtdioden-Array mit einer Vielzahl von in einer Matrix aus Zeilen und Spalten angeordneten Leuchtdioden (1), die mit einem Gehäuse (2) mit einer domartigen Oberseite (4) und mit einer Basisplatte (3) versehen sind, aus der Anschlußstifte (5) herausgeführt sind, ermöglicht eine maximale Beleuchtungsdichte und eine gleichmäßige Beleuchtung dadurch, daß die Leuchtdioden (1) mit ihren Basisplatten (3) auf einer Montage-Lochplatte (7) ringförmig flächig aufliegen und mit Wölbungen (6) und den Anschlußdrähten auf der Unterseite der Basisplatte (3) in ein zugehöriges Loch (8) der Montage-Lochplatte (7) ragen und in der Matrix mit minimalem Abstand zueinander angeordnet sind.

Eine bevorzugte Verwendung des Leuchtdioden-Arrays ergibt sich für die Durchführung einer Dunkelfeldbeleuchtung für eine ebene Oberfläche.

## Beschreibung

Die Erfindung betrifft ein Leuchtdioden-Array mit einer Vielzahl von in einer Matrix aus Zeilen und Spalten angeordneten Leuchtdioden, die mit einem Gehäuse mit einer domartigen Oberseite und mit einer Basisplatte versehen sind, aus der Anschlußstifte herausgeführt sind. Die Erfindung betrifft ferner ein Verfahren zur Herstellung des Leuchtdioden-Arrays sowie eine Verwendung des Leuchtdioden-Arrays zur Erzeugung einer Beleuchtung einer ebenen Oberfläche.

Leuchtdioden-Arrays der genannten Art sind zu Beleuchtungszwecken bekannt. Sie dienen dazu, mit einfachen und billigen, in ihrer Leuchtintensität begrenzten Leuchtdioden eine relativ hohe Leuchtintensität zu erzeugen, in dem das Licht der Vielzahl von Leuchtdioden verwendet wird, beispielsweise um eine Fläche zu beleuchten. Der Vorteil derartiger Leuchtdioden-Arrays besteht darin, daß Leuchtdioden einfach steuerbar sind und eine hohe Lebensdauer aufweisen, die durch Ein- und Ausschaltvorgänge nicht beeinträchtigt wird. Mit dem bekannten Leuchtdioden-Arrays ist eine Beleuchtung dann unproblematisch realisierbar, wenn es lediglich auf die Ausstrahlung einer gewissen Lichtmenge ankommt, wobei gewisse Unregelmäßigkeiten in Kauf zu nehmen sind.

Eine Präzisionsbeleuchtung mit einer hohen Gleichmäßigkeit der Ausleuchtung scheitert daran, daß die Leuchtdioden, die durch Lötung mit einer Ansteuerungsplatine verbunden werden, nach dem Verlöten nicht exakt ausgerichtet sind. Es ist bekannt, die Leuchtdioden einzeln in ein Gehäuse einzusetzen und dadurch eine exakte Ausrichtung zu ermöglichen. Diese Anordnung hat jedoch den Nachteil, daß die Leuchtdioden dabei nur in einigem Abstand voneinander angeordnet werden können, so daß eine hohe Beleuchtungsintensität nicht mehr erreichbar ist.

Der vorliegenden Erfindung liegt somit das Problem zugrunde, ein Leuchtdioden-Array zu erstellen, das sowohl eine gleichmäßige Ausleuchtung als auch eine hohe Beleuchtungsdichte ermöglicht.

Zur Lösung dieses Problems ist erfindungsgemäß ein Leuchtdioden-Array der eingangs erwähnten Art dadurch gekennzeichnet, daß die Leuchtdioden mit ihren Basisplatten auf einer Montage-Lochplatte ringförmig flächig aufliegen und mit Wölbungen und den Anschlußdrähten auf der Unterseite der Basisplatte in ein zugehöriges Loch der Basisplatte ragen und in der Matrix mit minimalem Abstand zueinander angeordnet sind.

In dem erfindungsgemäßen Leuchtdioden-Array sind die Leuchtdioden somit praktisch ohne Abstand voneinander angeordnet, stoßen also mit ihrem Gehäuse bzw. Basisplatten aneinander. Sie sind dennoch in dem Leuchtdioden-Array exakt parallel zueinander ausgerichtet, weil sie mit ihren Basisplatten auf einer Montage-Lochplatte ringförmig flächig aufliegen. Diese Anordnung bietet den Vorteil, daß die auf der Unterseite regelmäßig im Bereich der Anschlußstifte vorhandenen Wölbungen, die regelmäßig durch ausgetretenes Epoxyharz auftreten, die flächige Abstützung und Ausrichtung der Leuchtdioden mittels der Basisplatten nicht stören. Sie ragen zusammen mit den Anschlußstiften in bzw. durch das zugehörige Loch der Montage-Lochplatte, so daß die Anschlußstifte auf der Unterseite der Montage-Lochplatte mit den zugehörigen Anschlüssen, beispielsweise auf einer gedruckten Schaltungsplatine, verlötet werden und dadurch das Leuchtdioden-Array befestigt wird. Somit ist sichergestellt, daß alle Leuchtdioden den gewünschten Abstrahlwinkel beibehalten und keine durch unterschiedliche Abstrahlwinkel entstehenden Ungleichmäßigkeiten auftreten.

Das erfindungsgemäße Leuchtdioden-Array erlaubt erstmals Präzisionsausleuchtungen mit hoher Gleichmäßigkeit. Demzufolge kann es bei dem erfindungsgemäßen Leuchtdioden-Array sinnvoll sein, daß die Leuchtdioden zeilenweise in Serie zueinander geschaltet und zeilenweise in ihrer Helligkeit steuerbar sind.

Diese Ausführungsform der Erfindung ist besonders zweckmäßig, wenn das Leuchtdioden-Array zur Erzeugung einer schräg auffallenden Beleuchtung einer ebenen Oberfläche derart verwendet wird, daß die in jeder Zeile befindlichen Leuchtdioden einen gleichen Abstand zur Oberfläche aufweisen, wobei die Zeilen der Leuchtdioden mit zunehmenden Abstand von der Oberfläche zunehmend hell gesteuert werden.

Auf diese Weise läßt sich bei einem schrägen Lichteinfall durch das Leuchtdioden-Array eine den schrägen Lichteinfall kompensierende gleichmäßige Beleuchtung eines Feldes der ebenen Oberfläche erreichen. Eine solche Anordnung ist insbesondere zweckmäßig für die Überprüfung einer Oberfläche auf das Vorhandensein von Fehler mit einer Dunkelfeldbeleuchtung, bei der regelmäßig ein schräger Lichteinfall mit einer Kamerabeobachtung mittels einer Matrixkamera erfolgt, die im wesentlichen senkrecht zur Oberfläche steht. Durch die zeilenweise gesteuerte Helligkeit kann für alle möglichen Anstellwinkel des Leuchtdioden-Arrays zur beleuchteten Oberfläche eine gleichmäßige Intensität der von der Oberfläche reflektierten Strahlung erzielt werden.

Die Ausrichtung der Leuchtdioden kann dadurch noch stabilisiert werden, daß die domartigen Oberseiten der Leuchtdioden in Löcher einer oberen Lochplatte ragen. Hierdurch gelingt eine parallele Ausrichtung der Leuchtdioden. Wenn dabei gemäß einer bevorzugten Ausführungsform wenigstens die zur Montageplatte zeigende Oberfläche und vorzugsweise auch die Innenseiten der Löcher der oberen Lochplatte für die Strahlung der Leuchtdioden absorbierend ausgebildet ist, wird mit der oberen Lochplatte die Aussendung von Nebenmaxima der Leuchtdioden verhindert, so daß von dem Leuchtdioden-Array nur im wesentlichen parallele Strahlung ausgesandt wird, da nicht parallele Strahlen auf die absorbierenden Flächen der oberen Lochplatte treffen und somit auch nicht als reflektierte Strahlen durch die Löcher hindurchtreten können. Auf diese Weise gelingt es, paralelles, gleichmäßiges und flächiges Licht mit dem erfindungsgemäßen Leuchtdioden-Array zu erzeugen.

Die erfindungsgemäße korrekte Ausrichtung des Leuchtdioden-Arrays wird bei der Herstellung des Leuchtdioden-Arrays durch die Verwendung der oberen Lochplatte sichergestellt, mit deren Löchern die domartigen Oberseiten der Leuchtdioden ausgerichtet und die Leuchtdioden mit ihren Basisplatten gegen die Montage-Lochplatte gedrückt werden, bis der Lötvorgang für die Anschlußstifte beendet ist. Insbesondere wenn die domartigen Oberseiten der Leuchtdioden mit das Licht der Leuchtdioden fokussierenden Linsen versehen sind, kann es zweckmäßig sein, die obere Lochplatte im Leuchtdioden-Array zu belassen. Es ist jedoch auch möglich, die obere Lochplatte nach dem Lötvorgang zu entfernen, so daß das Leuchtdioden-Array zur Oberseite hin durch die Leuchtdiodengehäuse ungestört gebildet ist. Die Verwendung der oberen Lochplatte bewirkt einerseits die korrekte Ausrichtung der einzelnen Leuchtdioden parallel zueinander, da sich die Leuchtdioden mit den domartigen Oberseiten in den zugehörigen Löchern der oberen Lochplatte selbst zentrieren. Darüber hinaus bewirkt zusätzlich das Andrücken der unteren, flächig aufliegenden Basisplatte der Leuchtdioden auf die Montage-Lochplatte, daß die Leuchtdioden mit der zentrierten Ausrichtung und fest an der Montage-Lochplatte anliegend durch Lötung stabil fixiert werden, so daß die obere Lochplatte nach der Beendigung des Lötvorganges ohne Nachteile und ohne Gefährdung der korrekten Ausrichtung der Leuchtdioden entfernt werden kann.

Die Erfindung soll im folgenden anhand eines in der Zeichnung dargestellten Ausführungsbeispiels näher erläutert werden. Es zeigen:
- Figur 1 -: eine Prinzipskizze eines Ausschnitts aus einem Leuchtdioden-Array
- Figur 2 -: eine schematisierte Darstellung der Abstrahlung einer Leuchtdiode durch eine obere Lochplatte hindurch.

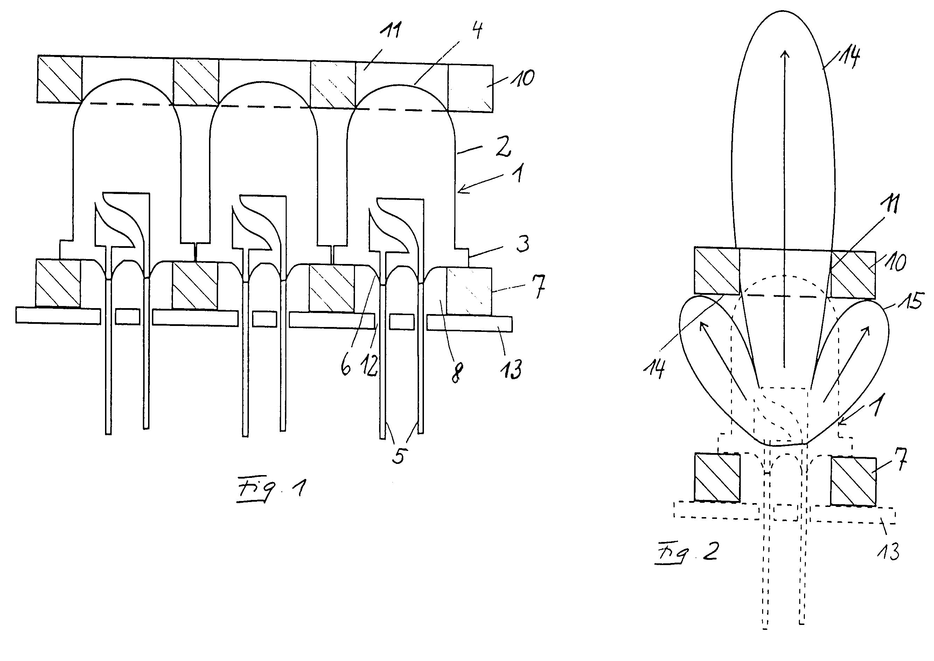

Figur 1 zeigt Leuchtdioden 1, die zur Durchführung einer Dunkelfeld-Beleuchtung vorzugsweise auch Infrarotdioden sein können. Jede Leuchtdiode 1 weist ein übliches, die Strahlung durchlassendes Gehäuse 2 auf, das sich von einer Basisplatte 3 im wesentlichen zylindrisch nach oben erstreckt und durch eine domartige Wölbung 4 abgeschlossen ist. Durch die Basisplatte 3 ragen nach unten zwei Anschlußstifte 5, die zur Fixierung der Leuchtdiode 1 in entsprechenden Aufnahmen, beispielsweise Löchern 12 einer gedruckten Schaltungsplatine 13 dienen. Auf der Unterseite der Basisplatte 3 befinden sich regelmäßig im Bereich der Anschlußstifte 5 nach unten vorstehende, bei der Fertigung unvermeidliche Wölbungen 6, die durch ausgetretenes Epoxyharz gebildet sind.

Die Ausrichtung der Vielzahl der Leuchtdioden 1 parallel zueinander erfolgt dadurch, daß die Leuchtdioden 1 mit ihrer Basisplatte 3 auf einer Montage-Lochplatte 7 aufliegen, die für jede Leuchtdiode 1 eine Durchgangsöffnung 8 aufweist, die so bemessen ist, daß die Anschlußstifte 5 durch das Loch 8 hindurch - und die Wölbungen 6 in das Loch 8 hineinragen können -, die Basisplatte 3 jedoch auf dem Rand 9 des Loches 8 ringförmig flächig aufliegt, und zwar ungestört durch die Wölbungen 6.

Zur Durchführung des Lötvorganges für die Anschlußstifte 5 wird auf die domförmige Wölbung 4 der Oberseite der Leuchtdioden 1 eine der Montage-Lochplatte 7 gleichende obere Lochplatte 10 aufgelegt, die somit für jede Leuchtdiode 1 ebenfalls ein Durchgangsloch 11 aufweist. Da das Durchgangsloch 11 einen kleineren Durchmesser als das Gehäuse 2 der Leuchtdiode 1 hat, ragt die domförmige Wölbung 4 der Oberseite der Leuchtdiode 1 in das Loch 11 hinein und zentriert sich dort automatisch, wenn die obere Lochplatte 10 genau fluchtend mit der Montage-Lochplatte 7 ausgerichtet ist. Die obere Lochplatte 10 wird so angebracht, daß sie die Basisplatte 3 der Leuchtdiode 1 gegen den ringförmigen Auflagerand 9 der Montage-Lochplatte 7 drückt, bis der Lötvorgang für die Anschlußstifte 5 beendet und die Leuchtdiode 1 somit dauerhaft fixiert ist. Danach kann die obere Lochplatte 10 entfernt werden. Die exakte Ausrichtung der Leuchtdioden 1 in dem erfindungsgemäßen Leuchtdioden-Array erlaubt gleichmäßige Ausleuchtungen, wobei es zur Vereinfachung der Verschaltung der Leuchtdioden sinnvoll sein kann, diese zeilenweise in Serie zu schalten und zeilenweise in ihrer Helligkeit steuerbar zu machen, indem jede Zeile des Leuchtdioden-Arrays mit einer Helligkeitssteuerung verbunden ist.

Figur 2 verdeutlicht, daß übliche Leuchtdioden 1 nicht nur ein im wesentlichen axial gerichtetes Leuchtmaximum 14 aufweisen sondern auch schräg abgestrahlte Nebenmaxima 15. Um mit dem Leuchtdiodenarray eine möglichst parallele Strahlung zu erreichen, ist es zweckmäßig, nur die Strahlung in dem im wesentlichen axialen Leuchtmaximum 14 auszunutzen, die durch die Öffnung 11 der oberen Lochplatte 10 hindurchtritt. Die Strahlung der Nebenmaxima 15 wird hingegen vorzugsweise durch die obere Lochplatte 10 nicht durchgelassen. Zu diesem Zweck ist es vorteilhaft, wenn die zur Montage-Lochplatte 7 zeigende Oberfläche 14 der oberen Lochplatte 10 absorbierend für die Strahlung der Leuchtdiode 1 ausgebildet ist.

## Patentansprüche

1. Leuchtdioden-Array mit einer Vielzahl von in einer Matrix aus Zeilen und Spalten angeordneten Leuchtdioden (1), die mit einem Gehäuse (2) mit einer domartigen Oberseite (4) und mit einer Basisplatte (3) versehen sind, aus der Anschlußstifte (5) herausgeführt sind, **dadurch gekennzeichnet, daß** die Leuchtdioden (1) mit ihren Basisplatten (3) auf einer Montage-Lochplatte (7) ringförmig flächig aufliegen und mit Wölbungen (6) und den Anschlußdrähten auf der Unterseite der Basisplatte (3) in ein zugehöriges Loch (8) der Montage-Lochplatte (7) ragen und in der Matrix mit minimalem Abstand zueinander angeordnet sind.

2. Leuchtdioden-Array nach Anspruch 1, dadurch gekennzeichnet, daß die Leuchtdioden (1) zeilenweise in Serie zueinander geschaltet und zeilenweise in ihrer Helligkeit steuerbar sind.

3. Leuchtdioden-Array nach Anspruch 1 oder 2, gekennzeichnet durch eine obere Lochplatte (10), in deren Löcher (11) die domartigen Oberseiten (4) ragen.

4. Leuchtdioden-Array nach Anspruch 3, dadurch gekennzeichnet, daß wenigstens die zur Montage-Lochplatte (7) zeigende Oberfläche (14) der oberen Lochplatte (10) für die Strahlung der Leuchtdioden (1) absorbierend ausgebildet ist.

5. Verwendung des Leuchtdioden-Arrays nach einem der Ansprüche 1 bis 4 zur Erzeugung einer schräg auffallenden Beleuchtung einer ebenen Oberfläche derart, daß die in einer Zeile befindlichen Leuchtdioden (1) einen gleichen Abstand zur Oberfläche aufweisen, mit mit zunehmenden Abstand zunehmend hell gesteuerten Zeilen von Leuchtdioden (1).

6. Verfahren zur Herstellung eines Leuchtdioden-Arrays nach einem der Ansprüche 1 bis 4, gekennzeichnet durch die Verwendung einer oberen Lochplatte (10), mit deren Löchern (11) die domartigen Oberseiten (4) der Leuchtdioden (1) ausgerichtet und die Leuchtdioden (1) mit ihren Basisplatten (3) gegen die Montage-Lochplatte (7) gedrückt werden, bis ein Fixiervorgang für die Anschlußstifte (5) beendet ist.

7. Verfahren nach Anspruch 6, dadurch gekennzeichnet, daß die obere Lochplatte (10) nach dem Lötvorgang entfernt wird.
